# FASCICULE DE BREVET EUROPEEN

(11) **EP 3 654 384 B1**
(45) Date de publication et mention de la délivrance du brevet: **02.08.2023**
(21) Numéro de dépôt: 19208091.9
(22) Date de dépôt: 08.11.2019
(51) Int. Cl.: H01L 29/40, H01L 29/861, H01L 29/205, H01L 29/51, H01L 29/778, H01L 29/20

(54) **DISPOSITIF SEMI-CONDUCTEUR A PLAQUE DE CHAMP**
HALBLEITERVORRICHTUNG MIT FELDPLATTE
SEMI-CONDUCTOR DEVICE WITH FIELD PLATE

(30) Priorité: 13.11.2018 FR 1860466
(43) Date de publication de la demande: 20.05.2020
(73) Titulaire: Commissariat à l'Energie Atomique et aux Energies Alternatives, 75015 Paris (FR)
(72) Inventeur: GWOZIECKI, Romain, 38054 GRENOBLE CEDEX 9 (FR); LE RHUN, Gwenaël, 38054 GRENOBLE CEDEX 9 (FR)
(74) Mandataire: Cabinet Camus Lebkiri

(56) Documents cités:
- WO-A1-2017/171752
- WO-A1-2018/063399
- US-A- 5 270 231
- US-A1- 2005 051 796
- US-A1- 2005 274 977
- US-A1- 2008 283 870
- US-A1- 2010 258 801
- US-A1- 2010 314 696
- XU XIAOKE ET AL: "Epitaxial growth of perovskite (111) 0.65PMN-0.35PT films directly on wurtzite GaN (0002) surface", APPLIED PHYSICS A MATERIALS SCIENCE & PROCESSING, SPRINGER BERLIN HEIDELBERG, BERLIN/HEIDELBERG, vol. 124, no. 7, 13 juin 2018 (2018-06-13) , pages 1-7, XP036556566, ISSN: 0947-8396, DOI: 10.1007/S00339-018-1905-X [extrait le 2018-06-13]

## Description

### DOMAINE TECHNIQUE DE L'INVENTION

La présente invention concerne un dispositif semi-conducteur à gaz d'électrons et à plaque de champ.

### ARRIERE-PLAN TECHNOLOGIQUE DE L'INVENTION

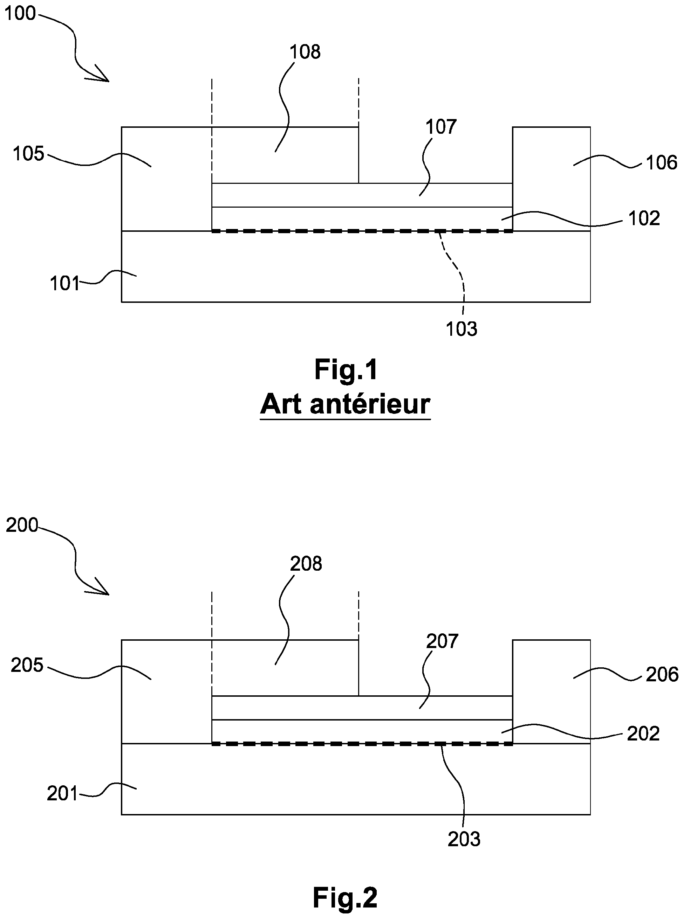

La figure 1 montre un exemple d'un dispositif semi-conducteur 100 à plaque de champ de l'art antérieur. Il s'agit en l'occurrence d'une diode de puissance latérale 100. La diode 100 comporte une hétérostructure formée par la superposition d'une première couche semi-conductrice 101 en nitrure de gallium (GaN) et d'une deuxième couche semi-conductrice 102 en nitrure d'aluminium-gallium (AlGaN). La diode 100 comporte une zone active 103 sous la forme d'un gaz d'électrons présent à l'interface entre les deux couches semi-conductrices 101, 102.

La diode 100 comporte également une anode 105 et une cathode 106 disposées sur la première couche semi-conductrice 101. Une couche d'isolation 107 s'étendant entre l'anode 105 et la cathode 106 est disposée sur la deuxième couche semi-conductrice 102. La couche d'isolation 107 comporte un matériau diélectrique tel qu'un oxyde de silicium (SiO₂) ou un nitrure de silicium (SiN). La plaque de champ est formée par une électrode métallique 108 disposée sur la couche d'isolation 107. La plaque de champ permet d'avoir une meilleur répartition du champ électrique afin d'éviter des pics de champ électrique qui pourraient endommager le dispositif semi-conducteur 100.

Un autre effet de la plaque de champ est celui de la déplétion du gaz d'électrons lorsque la diode 100 est polarisée en mode bloqué. Cette déplétion permet de réduire le courant de fuite de la diode 100 polarisée en inverse. La tension de polarisation pour laquelle le gaz d'électrons est complètement déplété dépend de la capacité de la couche d'isolation 107, donc de son épaisseur et de la permittivité du matériau diélectrique qui la compose. Par conséquent, afin de bloquer plus rapidement la diode 100, il est possible d'augmenter la capacité de la couche d'isolation 107, par exemple en diminuant son épaisseur et/ou en utilisant un matériau ayant une plus grande permittivité.

Un inconvénient à choisir un matériau diélectrique ayant une plus grande permittivité est que cela augmente le champ électrique dans la diode 100, notamment dans les couches semi-conductrices situées sous la couche d'isolation 107. Pour les fortes valeurs de tension en mode de polarisation bloqué, la diode 100 peut donc subir des dégradations, par exemple un claquage des couches semi-conductrices.

De plus, un inconvénient à réduire l'épaisseur de la couche d'isolation est que cette dernière devient plus difficile à former et qu'elle présente une tension de claquage plus faible et donc un risque accru d'être endommagée.

Le document US 2010/258801 intitulé « Semiconductor component including a lateral transistor component », le document WO 2017/171752 intitulé « Transistors comprenant un ensemble source/drain en relief rétracté pour réduire les capacités parasites », le document US 2010/314696 intitulé « Field-effect transistor and method of fabricating same », le document WO 2018/063399 intitulé « Formation d'espaceur en couches pour longueurs de canal ultracourtes et plaques de champ décalées », le document US 2005/274977 intitulé « Nitride semiconductor device » et le document US 2005/051796 intitulé « Wide bandgap transistor devices with field plates » sont connus de l'état de la technique.

### RESUME DE L'INVENTION

L'invention est exposée dans le jeu de revendications annexé.

### BREVE DESCRIPTION DES FIGURES

L'invention et ses différentes applications seront mieux comprises à la lecture de la description qui suit et à l'examen des figures qui l'accompagnent, parmi lesquelles :
- la figure 1 est une vue en coupe transversale d'un dispositif semi-conducteur à plaque de champ selon l'art antérieur ;
- la figure 2 est une vue en coupe transversale d'un dispositif semi-conducteur à plaque de champ selon un mode de réalisation de l'invention ;
- la figure 3 est un exemple d'une courbe de variation de la permittivité relative d'un matériau diélectrique non-linéaire en fonction du champ électrique.

Les figures ne sont présentées qu'à titre indicatif et nullement limitatif de l'invention.

Pour plus de clarté, les éléments identiques ou similaires sont repérés par des signes de référence identiques sur toutes les figures.

### DESCRIPTION DETAILLEE D'AU MOINS UN MODE DE REALISATION

Un mode de réalisation d'un dispositif semi-conducteur 200 selon l'invention va maintenant être décrit en référence à la figure 2. Le dispositif semi-conducteur 200 se présente sous la forme d'une diode de puissance latérale.

Le dispositif semi-conducteur 200 comporte une structure semi-conductrice disposée sur un substrat (non représenté). Le substrat peut être en silicium (Si), en carbure de silicium (SiC), en nitrure de galium (GaN), en saphir ou dans tout autre matériau approprié.

Dans ce mode de réalisation, la structure semi-conductrice est une hétérostructure formée par l'empilement de couches semi-conductrices ayant des bandes d'énergie interdite différentes. La structure semi-conductrice du dispositif semi-conducteur 200 comporte par exemple une première couche semi-conductrice 201 disposée sur le substrat et une deuxième couche semi-conductrice 202 disposée sur la première couche semi-conductrice 201.

Selon un autre mode de réalisation ne relevant pas de l'invention et présent à titre indicatif, la structure semi-conductrice peut être une structure simple, c'est-à-dire une structure formée par une couche d'un même matériau semi-conducteur mais qui comprend des zones dopées selon des types de conductivité opposés. Dans ce cas, le matériau utilisé pour réaliser la structure semi-conductrice peut être du silicium (Si), du germanium (Ge), du carbure de silicium (SiC) ou de l'oxyde de zinc (ZnO).
Dans le mode de réalisation de la figure 2, la première couche semi-conductrice 201 et la deuxième couche semi-conductrice 202 sont composées de matériaux semi-conducteurs de natures physiques différentes. En l'occurrence, la première couche semi-conductrice 201 est en nitrure de gallium (GaN) et la deuxième couche semi-conductrice 202 est en nitrure d'aluminium-gallium (AlGaN).

Dans d'autres modes de réalisation, la première couche semi-conductrice 201 et la deuxième couche semi-conductrice 202 peuvent respectivement être en GaAs et AlₓGa₁₋ₓAs (x<0.25), ou en Ga_{y}ln_{1-y}As (y-0.8) et AlₓGa₁₋ₓAs (x<0.25), et plus généralement des structures HEMT (de l'anglais « High-Electron-Mobility Transistor ») à base de matériaux III-V.

La structure semi-conductrice forme une zone active 203, c'est-à-dire une zone qui contribue au fonctionnement du dispositif semi-conducteur 200. Dans le cas de la diode 200 de la figure 2, la zone active 203 est une zone de canal formée par un gaz d'électrons présent à l'interface entre la première couche semi-conductrice 201 et la deuxième couche semi-conductrice 202.

Le dispositif semi-conducteur 200 comporte également une première électrode 205 et une deuxième électrode 206 disposées sur la structure semi-conductrice. La première électrode 205 et la deuxième électrode 206 forment respectivement l'anode et la cathode de la diode 200. La première électrode 205 et la deuxième électrode 206 sont par exemple disposées directement sur la première couche semi-conductrice 201, la deuxième couche semi-conductrice 202 s'étendant entre la première électrode 205 et deuxième électrode 206. Les électrodes 205, 206 sont de préférence en un matériau métallique, tel que de l'aluminium dopé cuivre (AI:Cu). Les électrodes 205, 206 peuvent être réalisées dans le même matériau ou dans des matériaux différents, par exemple en aluminium dopé cuivre Al:Cu pour la deuxième électrode 206 et en nitrure de titane TiN pour la première électrode 205. Les électrodes 205, 206 peuvent de plus être constituées de plusieurs matériaux métalliques empilés, par exemple titane Ti puis aluminium dopé cuivre AI:Cu pour la deuxième électrode 206 ; et nitrure de titane TiN puis tungstène W pour la première électrode 205. D'autres matériaux possibles pour les électrodes 205, 206 sont le Nickel (Ni) ou des multicouches de type Nickel-Au (Ni/Au).

Le dispositif semi-conducteur 200 comporte également une couche d'isolation 207 disposée sur la structure semi-conductrice et une plaque de champ 208 disposée sur la couche d'isolation 207. La plaque de champ 208 est formée par une électrode qui recouvre partiellement la couche d'isolation 207. La plaque de champ permet d'éviter les pics de champ électrique dus aux discontinuités abruptes entre les différents matériaux. Il s'agit de discontinuités soit au niveau du profil de potentiel, soit au niveau des concentrations de charges électriques.

Dans ce mode de réalisation, la plaque de champ 208 fait partie de la première électrode 205 et en est une extension. Alternativement, la plaque de champ peut être reliée électriquement à une autre électrode ou bien être isolée électriquement des autres électrodes.

La couche d'isolation 207 est par exemple disposée sur la deuxième couche semi-conductrice 202. La couche d'isolation 207 est réalisée à partir d'un matériau diélectrique non-linaire, c'est-à-dire un matériau diélectrique dont la permittivité dépend du champ électrique. Dans le contexte de l'invention, la permittivité du matériau diélectrique est élevée sous un champ électrique faible, c'est-à-dire proche de 0 V/m, et elle est faible sous un champ électrique élevée, par exemple supérieur à 50 kV/M. Autrement dit, la permittivité du matériau diélectrique diminue lorsque le champ électrique augmente.

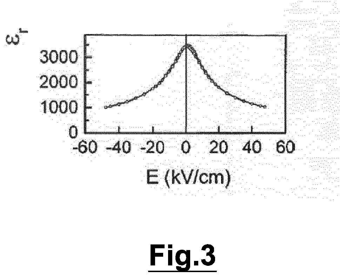

La figure 3 est un exemple de courbe représentant la variation de la permittivité relative εᵣ du matériau diélectrique non-linéaire en fonction du champ électrique. Dans cet exemple, le matériau diélectrique non-linéaire est du titanate de strontium-bismuth ((SrBi)TiOs). On constate que la permittivité relative εᵣ est maximale pour un champ électrique E proche de 0 V/cm et diminue à mesure que la valeur absolue du champ électrique E qui traverse le matériau diélectrique augmente.

Ainsi, grâce à la présente invention, il est possible à la fois d'améliorer la déplétion des charges électriques de la zone active à faible champ et d'améliorer la fiabilité du dispositif semi-conducteur 200 à fort champ.

Dans le contexte de l'invention, les termes « faible » et « élevée » et leurs synonymes, lorsqu'ils font référence à la permittivité du matériau diélectrique, doivent être interprétés dans le propre référentiel du matériau diélectrique. Autrement dit, la permittivité à fort champ est faible par rapport à la permittivité à faible champ, qui elle est donc élevée. Le matériau diélectrique non-linéaire présente un rapport entre sa permittivité minimale et sa permittivité maximale qui est de préférence inférieur à 70 %, plus préférentiellement inférieur à 50 % et plus préférentiellement encore inférieur à 30 %. La permittivité relative maximale du matériau diélectrique non-linéaire est de préférence supérieure ou égale à 1000.

La couche d'isolation 207 présente une épaisseur de préférence inférieure à 300 nm, et plus préférentiellement comprise entre 10 nm et 200 nm. Ainsi, l'épaisseur de la couche d'isolation 207 est la plus fine possible, qui permet une déplétion plus rapide du gaz d'électron sous-jacent, tout en restant intègre, sans chemin de fuite parasite. En fonction des valeurs de permittivité du matériau diélectrique à faible champ et à fort champ, il est possible d'ajuster la capacité de la couche d'isolation 207 en adaptant son épaisseur de manière à obtenir les conditions de déplétion de la zone active souhaitées et une protection contre le claquage appropriée.

Le matériau diélectrique non-linéaire est un matériau qui cristallise dans la structure perovskite ABOs. Plus précisément, le matériau diélectrique non-linéaire est en phase ferroélectrique relaxeur ou selon des modes de réalisation ne relevant pas de l'invention et présentés à titre indicatif, ou phase ferroélectrique ou en phase paraélectrique. La phase ferroélectrique a la particularité de présenter un cycle d'hystérésis. La plupart des matériaux ferroélectriques présentent une phase paraélectrique à suffisamment haute température ; la température de transition paraélectrique-ferroélectrique est appelée température de Curie Te. Un même matériau peut donc se trouver en phase paraélectrique ou ferroélectrique selon la température. Par exemple, le PZT présente une température de Curie Tc de l'ordre de 350-450°C (suivant la composition Zr/Ti) : il se trouve en phase paraélectrique au-delà de 350-450°C, ou en phase ferromagnétique sinon. Certains matériaux ont une transition de phase à basse température, proche de la température ambiante, ce qui permet de les utiliser dans leur phase paraélectrique : c'est par exemple le cas du BST ou BCTZ. Les ferromagnétiques relaxeurs se caractérisent quant à eux par un large pic de permittivité en fonction de la température, dépendant de la fréquence du champ de mesure

Le matériau diélectrique non-linéaire est une solution solide appartenant à la liste suivante :
- selon un mode de réalisation ne relevant pas de l'invention et présenté à titre indicatif, en phase ferroélectrique, c'est-à-dire présentant un cycle d'hystérésis et une température de Curie Tc relativement élevée :
   ∘ les composés de type PZT de formule Pb(Zr, Ti)Os ;
   ∘ les composés de type PT de formule PbTiOs ;
   ∘ les composés de type BT de formule BaTiOs ;
   ∘ les composés de type KNN de formule (K, Na)NbOs ;
   ∘ les composés de type BNT-BT de formule (Bi_{1/2}Na_{1/2})TiO₃-BaTiO₃ ;
- selon un mode de réalisation de la présente invention, en phase ferroélectrique relaxeur :
   ∘ les composés de type PMN de formule Pb[Mg_{1/3}Nb_{2/3}]O₃ ou de type PMN-PT de formule Pb[Mg_{1/3}Nb_{2/3}]O₃-PbTiO₃ dont la permittivité relative varie entre environ 2000 à faible champ et environ 300 à fort champ ;
   ∘ les composés de type PLZT de formule (Pb, La)(ZrTi)Os dont la permittivité relative est d'environ 4000 à faible champ, la permittivité relative décroissant à fort champ jusqu'à une valeur qui dépend de la concentration des différents éléments ;
   ∘ les composés de type PST de formule Pb(Sc_{1/2}Ta_{1/2})O₃ dont la permittivité relative entre environ 5000 à faible champ et environ 1800 à 20 kV/cm ;
   ∘ les composés de type PSN de formule Pb(Sc_{1/2}Nb_{1/2})O₃ ;
   ∘ les composés de type BNT de formule (Bi_{1/2}Na_{1/2})TiO₃ ;
   ∘ les composés de type BZT de formule Ba(Ti, Zr)Os ;
- selon un mode de réalisation ne relevant pas de l'invention et présenté à titre indicatif, en phase paraélectrique, présentant une température de Curie Tc relativement basse, c'est-à-dire proche de la température ambiante :
   ∘ les composés de type BST de formule (Ba, Sr)TiOs ;
   ∘ les composés de type BCTZ de formule Ba(Ti_{0.8}Zr_{0.2})O₃-(Ba_{0.7}Ca_{0.3})TiO₃.

Le tableau ci-dessous établit une comparaison entre le dispositif semi-conducteur 200 de la figure 2 dans lequel la couche d'isolation 207 est en PMN et le dispositif semi-conducteur 100 de la figure 1 dans lequel la couche d'isolation 107 est en nitrure de silicium (SiN) qui a une permittivité relative εᵣ constante. Différentes épaisseurs e_{AlGaN} de la deuxième couche semi-conductrice 102, 202 et différentes épaisseurs e_{diel} de la couche d'isolation 107, 207 sont considérées.

| Matériau diélectrique | εᵣ | e_{AlGaN} (nm) | e_{diel} (nm) | V_{P} (V) | E_{max_diel} (MV/cm) |
|---|---|---|---|---|---|
| SiN | 7,9 | 24 | 10 | 5,88 | 1,6 |
| | | | 3 | 4,76 | |
| | | 12 | 10 | 3,74 | |
| | | | 3 | 2,62 | |
| PMN | 2000 | 24 | 200 | 4,4 | 0,006 |
| | | | 150 | 4,34 | |
| | | | 100 | 4,31 | |
| | | 12 | 200 | 2,27 | |
| | | | 150 | 2,2 | |
| | | | 100 | 2,17 | |

On constate que la tension de pincement V_{P} de la zone de canal est plus faible dans le cas de l'invention que dans l'art antérieur, ce qui représente une amélioration. En effet, plus la tension de pincement V_{P} est basse, plus le courant de fuite est faible. L'utilisation d'un matériau diélectrique non-linéaire permet d'avoir une couche d'isolation plus épaisse qui est moins sujette à des fuites parasites et qui est également plus facile à réaliser. La couche d'isolation peut alors être formée en déposant successivement plusieurs sous-couches de plus faible épaisseur jusqu'à atteindre l'épaisseur totale désirée. Cela permet de limiter davantage les fuites car celles-ci sont dues à des défauts dans le matériau diélectrique. Par conséquent, en procédant avec plusieurs sous-couches, les défauts ne sont pas alignés d'une sous-couche à l'autre et ne traversent donc pas toute la couche d'isolation.

Par ailleurs, pour une même tension de polarisation, on constate également une diminution du champ électrique maximal E_{max_diel} traversant la couche d'isolation. La fiabilité du dispositif semi-conducteur 200 à fort champ est donc améliorée.

Il est à noter que bien qu'elle a été décrite en référence à une diode, la présente invention peut être appliquée à un transistor ou à un autre dispositif semi-conducteur.

Dans le cas d'un transistor, les trois électrodes, à savoir la source, la grille et le drain, sont en contact avec la zone active 203. En particulier, la couche d'isolation 207 ne peut pas être localisée entre la grille et la zone active 203.

Naturellement, l'invention n'est pas limitée aux modes de réalisation décrits en référence aux figures et des variantes pourraient être envisagées sans sortir du cadre de l'invention. Le dispositif semi-conducteur peut notamment présenter une architecture verticale au lieu d'une architecture latérale.

## Revendications

1. Dispositif (200) semi-conducteur comportant :
- un substrat ;
- une hétérostructure semi-conductrice disposée sur le substrat, l'hétérostructure semi-conductrice comprenant au moins une première couche semi-conductrice (201) et une deuxième couche semiconductrice (202) disposée sur la première couche semiconductrice (201) et formant une zone active (203) sous la forme d'un gaz d'électrons présent à l'interface entre la première couche semi-conductrice (201) et la deuxième couche semiconductrice (202) ;
- une couche d'isolation (207) disposée sur l'hétérostructure semi-conductrice ;
- une plaque de champ (208) couvrant une partie de la couche d'isolation (207) ;
le dispositif (200) semi-conducteur étant une diode,
ou un transistor présentant une électrode de source, une électrode de grille et une électrode de drain, dans lequel transistor chaque électrode est en contact avec la zone active (203) et la couche d'isolation (207) n'est pas localisée entre l'électrode de grille et la zone active (203) ;
le dispositif (200) semi-conducteur étant **caractérisé en ce que**
la couche d'isolation (207) comporte un matériau diélectrique non-linéaire présentant une permittivité qui diminue à mesure qu'un champ électrique traversant le matériau diélectrique augmente, le matériau diélectrique non-linéaire étant une solution solide en phase ferroélectrique relaxeur de type PMN, PMN-PT, PLZT, PST, PSN, BNT ou BZT.

2. Dispositif semi-conducteur (200) selon la revendication 1, **caractérisé en ce que** le matériau diélectrique présente une permittivité minimale et une permittivité maximale, le rapport entre la permittivité minimale et la permittivité maximale étant inférieur à 70 %.

3. Dispositif semi-conducteur (200) selon l'une quelconque des revendications 1 et 2, **caractérisé en ce que** le matériau diélectrique présente une permittivité relative maximale au moins égale à 1000.

4. Dispositif semi-conducteur (200) selon l'une quelconque des revendications 1 à 3, **caractérisé en ce que** la couche d'isolation (207) présente une épaisseur inférieure à 300 nm.

## Patentansprüche

1. Halbleitervorrichtung (200) mit:
- einem Substrat;
- einer Halbleiter-Heterostruktur, die auf dem Substrat angeordnet ist, wobei die Halbleiter-Heterostruktur mindestens eine erste Halbleiterschicht (201) und eine zweite Halbleiterschicht (202) umfasst, die auf der ersten Halbleiterschicht (201) angeordnet ist und einen aktiven Bereich (203) in Form eines Elektronengases bildet, das an der Grenzfläche zwischen der ersten Halbleiterschicht (201) und der zweiten Halbleiterschicht (202) vorhanden ist;
- eine Isolierschicht (207), die auf der Halbleiter-Heterostruktur angeordnet ist;
- eine Feldplatte (208), die einen Teil der Isolierschicht (207) bedeckt;
wobei die Halbleitervorrichtung (200) eine Diode ist,
oder ein Transistor mit einer Source-Elektrode, einer Gate-Elektrode und einer Drain-Elektrode, wobei in diesem Transistor jede Elektrode mit dem aktiven Bereich (203) in Kontakt ist und die Isolierschicht (207) nicht zwischen der Gate-Elektrode und dem aktiven Bereich (203) angeordnet ist; wobei die Halbleitervorrichtung (200) **dadurch gekennzeichnet ist, dass** die Isolierschicht (207) ein nichtlineares dielektrisches Material umfasst mit einer Permittivität, die abnimmt, wenn ein elektrisches Feld, das das dielektrische Material durchquert, zunimmt, wobei das nichtlineare dielektrische Material eine feste Lösung in einer ferroelektrisch-relaxor Phase vom Typ PMN, PMN-PT,PLZT,PST,PSN,BNT oder BZT ist.

2. Halbleitervorrichtung (200) nach Anspruch 1, **dadurch gekennzeichnet, dass** das dielektrische Material eine minimale Permittivität und eine maximale Permittivität aufweist, wobei das Verhältnis zwischen der minimalen Permittivität und der maximalen Permittivität weniger als 70 % beträgt.

3. Halbleitervorrichtung (200) nach einem der Ansprüche 1 oder 2, **dadurch gekennzeichnet, dass** das dielektrische Material eine maximale relative Permittivität von mindestens 1000 aufweist.

4. Halbleitervorrichtung (200) nach einem der Ansprüche 1 bis 3, **dadurch gekennzeichnet, dass** die Isolierschicht (207) eine Dicke von weniger als 300 nm aufweist.

## Claims

1. Semiconductor device (200) comprising:
- a substrate;
- a semiconductor heterostructure arranged on the substrate, the semiconductor heterostructure comprising at least a first semiconductor layer (201) and a second semiconductor layer (202) arranged on the first semiconductor layer (201) and forming an active zone (203) in the form of a gas of electrons present at the interface between the first semiconductor layer (201) and the second semiconductor layer (202);
- an insulator layer (207) arranged on the semiconductor heterostructure;
- a field plate (208) covering a part of the insulator layer (207);
the semiconductor device (200) being a diode or a transistor having a source electrode, a gate electrode and a drain electrode, each electrode of the transistor being in contact with the active zone (203) and the insulator layer 207 being not located between the gate electrode and the active zone (203), said semiconductor device (200) being **characterized in that** the insulator layer (207) comprises a non-linear dielectric material having a permittivity that decreases as an electric field traversing the dielectric material increases, the non-linear dielectric material being a solid solution in a relaxor ferroelectric phase of PMN, PMN-PT, PLZT, PST, PSN, BNT or BZT type.

2. Semiconductor device (200) according to claim 1, **characterised in that** the dielectric material has a minimum permittivity and a maximum permittivity, the ratio between the minimum permittivity and the maximum permittivity being less than 70 %.

3. Semiconductor device (200) according to any of claims 1 and 2, **characterised in that** the dielectric material has a maximum relative permittivity at least equal to 1000.

4. Semiconductor device (200) according to any of claims 1 to 3, **characterised in that** the insulator layer (207) has a thickness less than 300 nm.
